# EUROPEAN PATENT SPECIFICATION

(11) **EP 0 588 403 B1**
(45) Date of publication and mention of the grant of the patent: **16.07.1997**
(21) Application number: 93202473.0
(22) Date of filing: 23.08.1993
(51) Int. Cl.: G01D 3/02

(54) **Method and apparatus for driving a gauge**
Verfahren und Vorrichtung zur Steuerung eines Messinstrumentes
Méthode et dispositif pour l'entraînement d'une jauge

(30) Priority: 14.09.1992 US 944378
(43) Date of publication of application: 23.03.1994
(73) Proprietor: DELCO ELECTRONICS CORPORATION, Kokomo Indiana 46902 (US)
(72) Inventor: Hawes, Kevin Joseph, Greentown, Indiana 46936 (US); Weber, Reynolds Patrick, Lafayette, Indiana 47905 (US)
(74) Representative: Denton, Michael John

(56) References cited:
- EP-A- 0 379 816
- EP-A- 0 457 134
- GB-A- 2 043 268
- PATENT ABSTRACTS OF JAPAN vol. 17, no. 302 (P-1553)10 June 1993 & JP-A-05 026 905 (KANSEI CORP.) 5 February 1993

## Description

This invention relates to a method and apparatus for driving an air core gauge.

A typical air core gauge comprises a magnetic rotor, two or more coils wound around the magnetic rotor, a spindle attached to the shaft of the magnetic rotor and a pointer tip on the end of the spindle. The magnetic rotor is pivotally mounted within the coils, to which an electric current is applied. When the electric current is applied to the coils, the coils generate a magnetic flux which acts upon the magnetic rotor causing rotation of the rotor until the rotor is aligned with the composite magnetic vector generated by the coils. The magnetic rotor causes the spindle to rotate, in turn rotating the pointer, which displays information by means of a gauge scale.

Typically, a metal shield surrounds the coil and magnet assembly to prevent external fields from disrupting the magnetic vector created by the coils. This metal shield may be referred to as the "can". In operation of the gauge, the can exhibits a slight residual magnetic field that affects the pointer deflection angle causing magnetic hysteresis. Air core gauges also have a mechanical hysteresis which affects the gauge operation but which is reduced by normal driving vibrations in the vehicle. The magnetic hysteresis in the can resists changes to the magnetic field created by the coils, thus affecting the resultant magnetic vector to which the rotor aligns itself and causing positional error in the pointer of the gauge.

The present invention seeks to provide an improved method and apparatus for driving a gauge.

EP-A-0379816 discloses an arrangement as detailed in the preambles of claims 1 and 5.
EP-A-0457134 discloses a method for correcting for internal friction in load cells or transducers of force measuring devices. GB-A-2043268 discloses an analogue indicator which uses a hysteresis circuit to discharge a capacitor into the windings of a motor.

Gauge driving apparatus and a method of driving an air core gauge in accordance with the present invention are characterised over EP-A-0379816 by the features specified in the characterising portions of claims 1 and 5 respectively.

In some embodiments, the adverse effects of the above-described mechanical limitations of air core gauge mechanisms can be reduced and increased accuracy, for example in vehicle information systems employing air core gauges can be provided.

Advantageously, there may be provided a vehicle speedometer with increased accuracy and/or a vehicle tachometer with increased accuracy.

In a preferred embodiment, there is provided a method including the steps of: (a) determining an ideal gauge position, (b) determining a centre angle representative of an assumed centre position of a magnetic hysteresis, (c) comparing the ideal gauge position to the centre angle, (d) developing a gauge position command responsive to 1) the ideal gauge position and 2) the comparison between the ideal gauge position and the centre angle and (e) driving the air core gauge according to the determined command.

In another embodiment, there is provided apparatus comprising an air core gauge, means for measuring a vehicle parameter, means for determining an ideal gauge position responsive to the parameter measurement, means for determining a centre position representative of an assumed centre of magnetic hysteresis, means for comparing the centre position with the ideal gauge position, means for determining a gauge command responsive to the ideal gauge position and the comparison, means for outputting the gauge command to the air core gauge and means for driving the air core gauge responsive to the output gauge command.

An embodiment of the present invention is described below, by way of example only, with reference to the accompanying drawings, in which:
Figure 1 illustrates a magnetic hysteresis curve of an air core gauge;
Figures 2 and 3 illustrate pointer error caused by magnetic hysteresis in an air core gauge;
Figure 4 is a graph illustrating an embodiment of compensation to be applied to an air core gauge;
Figure 5 illustrates schematically the compensation of Figure 3 applied to an air core gauge;
Figure 6 is a block diagram of an embodiment of compensation apparatus;
Figure 7 is a flow chart of an embodiment of routine for the apparatus of Figure 6; and
Figure 8 is a graph of experimental results showing improved accuracy in a speedometer system based on the apparatus of Figure 6.

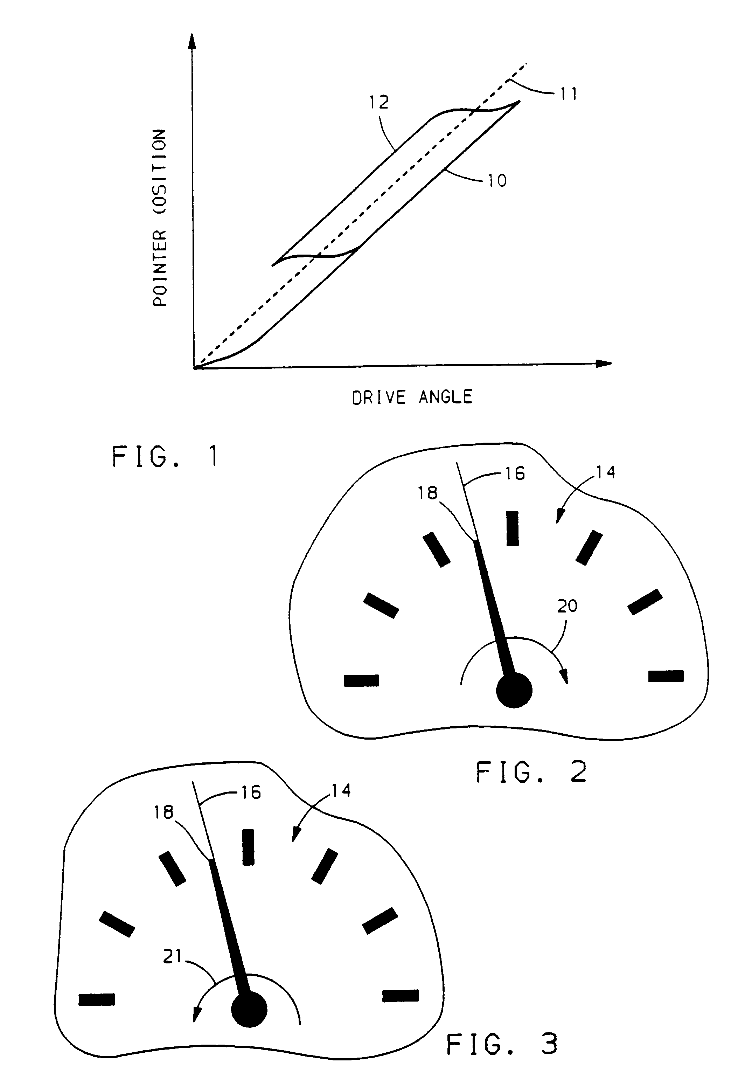

Referring to Figure 1, the graph shown illustrates the problem of gauge hysteresis. Line 11 represents an ideal pointer position against drive angle for an air core gauge. If an angular position command is applied to the gauge, the actual angular position of the gauge follows the hysteresis curves represented by traces 10 and 12. If the angular position of the gauge is increasing, the actual position of the gauge lags the ideal position, being slightly less than the ideal position, as shown by trace 10. Similarly, if the angular position of the gauge is decreasing, the actual position of the gauge is slightly higher than the ideal position, as indicated by trace 12 on the graph.

Figures 2 and 3 depict the effect of hysteresis in relation to an air core gauge. For the gauge display 14 shown in Figure 2, if the angular position of the gauge is increasing, as represented by arrow 20, the actual position of pointer 18 is slightly less than the drive angle, represented by line 16. Similarly, in Figure 3, when the angular position of pointer 18 is decreasing, as represented by arrow 21, the actual angular position of pointer 18 is slightly greater than the drive angle 17. These variances of pointer position in relation to the drive angle applied to the air core gauge are due, in large part, to magnetic hysteresis in the gauge mechanism.

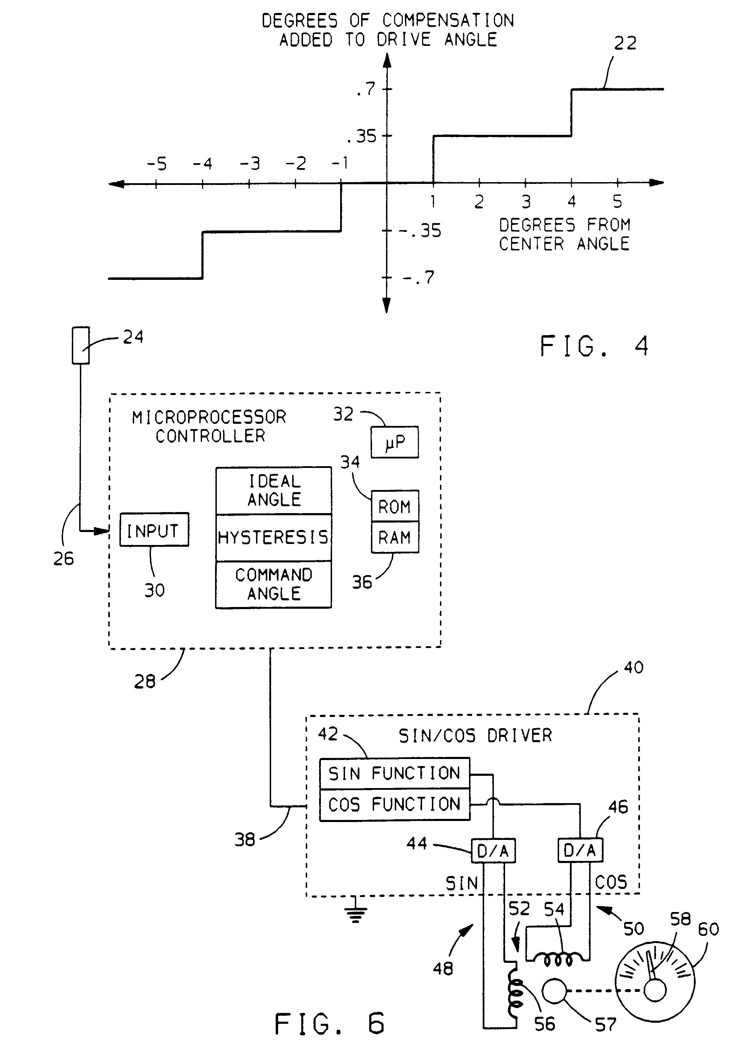

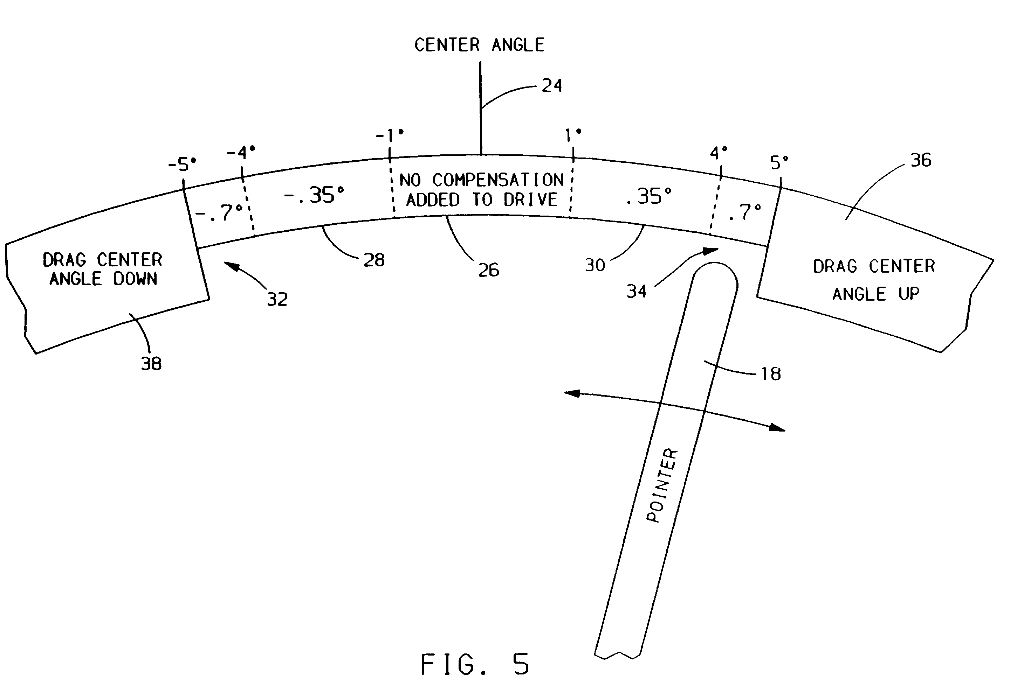

Referring to Figure 4, trace 22 in the graph shown illustrates an embodiment of control structure for compensating for magnetic hysteresis in an air core gauge. The horizontal axis represents the difference between the desired pointer position and a centre angle representing a position of assumed zero magnetic hysteresis. In general, the centre angle is determined through the assumption that the angular position of the rotor (and pointer) at which there is zero magnetic hysteresis lags the commanded pointer position by 5°.

For example, at start-up both the initial pointer position and centre angle are assumed to be zero. If the pointer is then commanded to move to the 15° position, the centre angle is assumed to lie at the 10° angular position. In a similar manner, if the pointer is again returned to the 0° position, the centre angle is assumed to move to the 5° angular position.

The command structure shown on Figure 4 illustrates the offset provided to the air core gauge to compensate for magnetic hysteresis. If the ideal gauge position is within 1° of the centre position, as determined in the manner described above, no offset is provided and the air core gauge is driven with a command representing the ideal gauge position. If the ideal gauge position is between 1-4° away from the centre angle, the gauge command is offset by a first amount, preferably 0.35° from the ideal command, in the direction away from the centre angle. For example, if the ideal position is between 1-4° greater than the centre angle, the air core gauge is driven with a command representing the ideal gauge position with a 0.35° offset added. Similarly, if the ideal gauge position is between 1-4° less than the centre angle, the air core gauge is driven with a command representing the ideal gauge position with a 0.35° offset subtracted from the ideal position. If the ideal gauge position is further than 4° away from the centre angle, then a second, greater, offset is added to the ideal position in the direction away from the centre angle to determine the actual command applied to the gauge. A suitable number for the second offset is 0.7°.

Figure 5 illustrates the operation of the above embodiment with relation to pointer 18 and angular positions on the gauge display. Assuming position 24 represents the determined centre angle, if the ideal pointer position is within the region 26, which falls +/-1° of centre angle 24, no compensation is made and the gauge command is set equal to the ideal pointer position. If the ideal pointer position falls in the region 30, between 1 and 4° greater than centre angle 24, the first offset is added to the ideal pointer position to determine the gauge command. If the ideal pointer position falls within the region 34, which represents any position greater than the region 30, the second offset is added to the ideal pointer position to determine the gauge command. Similarly, if the ideal pointer position falls within the region 28, between 1° and 4° less than centre angle 24, the first offset is subtracted from ideal gauge position to determine the gauge command and if the ideal pointer position falls within the region 32, which represents any position less than region 28, the second offset is subtracted from the ideal gauge command to determine the applied gauge command.

Regions 36 and 38 are regions in which the ideal angular positions are greater than or less than the centre angle by at least 5°. If the ideal pointer position falls within region 36, the centre angle is adjusted to a new centre angle that is 5° less than the commanded gauge position. Similarly, if the ideal gauge position falls within region 38, after the gauge command is determined, the centre angle is adjusted to be 5° greater than the commanded gauge angle.

Figure 6 illustrates an embodiment of apparatus suitable for use in a vehicle speedometer (or tachometer) system. The apparatus shown includes a sensor 24, a microprocessor controller 28 including a microprocessor 32, ROM and RAM memories 34 and 36, and input unit 30. Serial data link 38 connects microprocessor controller 28 to a sine/cosine gauge driver circuit 40, including a sine and cosine function generator 42, and digital-to-analogue converters 44 and 46. Gauge driver circuit 40 is connected to and drives gauge 52.

In operation, sensor 24 picks up a rotational speed signal from the vehicle transmission to sense vehicle speed in a manner well known to those skilled in the art. The signal is fed on line 26 to microprocessor controller 28. The microprocessor controller 28 converts the signal on line 26 to a numerical signal representing vehicle speed. The vehicle speed signal is then converted to an angular position signal representing the ideal angular position of pointer 58 in relation to graphic scale 60 of gauge 52.

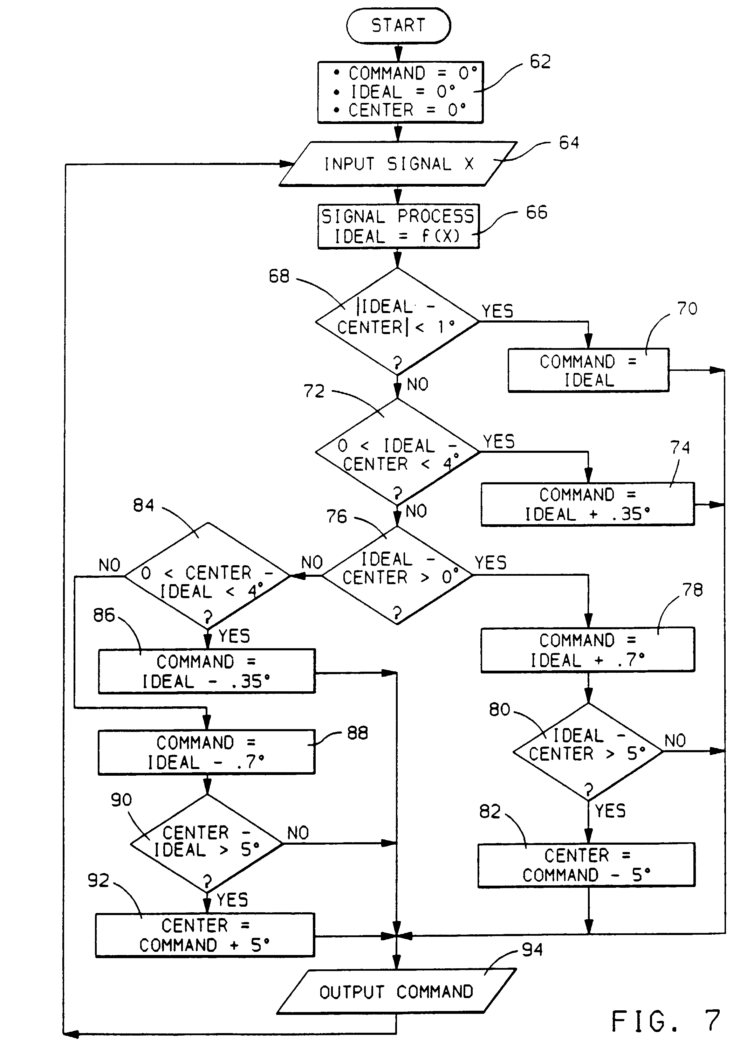

Developing the ideal angular position signal may be accomplished in a manner such as looking up, in a look-up table, an angular position signal in response to the developed speed signal. Other processing may be involved such as adding a term to compensate for the pointer tip weight. This may also be done by obtaining the compensation term from a look-up table in response to the angular position signal and is in the form of a reference angle which is then added to the angular position signal to obtain the ideal angular position signal. Hysteresis compensation is then applied to the ideal angular position signal to determine the gauge command in the manner described above and as set forth in more detail below with respect to Figure 7.

The gauge command, typically in 10-bit format in this embodiment, is output on serial data link 38 which transfers the gauge command to sine/cosine driver 40. Sine/cosine drivers, such as sine/cosine driver 40, are well known to those skilled in the art and come in a variety of forms responsive to digital and/or analogue signals. In the digital implementation shown, sine/cosine driver 40 receives the 10-bit word in an input latch (not shown), which latches in the gauge command and feeds it to function generator 42. Function generator 42 generates the sine and cosine components of the gauge command represented by the 10-bit word received through line 38. The sine and cosine components of the command are converted to analogue signals through digital-to-analogue converters 44 and 46 and output to gauge 52 through lines 48 and 50. Line 48 provides the sine component of the command to coil 56 and line 50 provides the cosine component of the gauge command to coil 54, which is mounted perpendicularly to coil 56. Coils 56 and 54 generate magnetic vectors comprising the sine and cosine components of the desired magnetic vector, respectively. The magnetic vectors generated by the two coils together form a composite magnetic vector operating on magnetic rotor 57, which rotates to align itself with the composite magnetic vector at the commanded angle (positive/negative hysteresis affect), in turn causing rotation of pointer 58 in relation to graphic scale 60 to provide speed information to the vehicle driver.

Referring to Figure 7, an embodiment of routine for controlling the controller 28 is shown. At start-up, step 62 sets the variables COMMAND, IDEAL and CENTRE to zero. At step 64 an input signal is received representing vehicle speed. The input signal can be in a variety of forms such as a frequency signal, a pulse count or any other known signal representative of vehicle speed. The apparatus in Figure 6 shows the input signal coming from speed sensor 24. However, this is an example implementation and the signal may come from other sources such as the vehicle microprocessor control unit, which itself receives a speed signal from a speed sensor, such as sensor 24.

Step 66 carries out general signal processing well known to those skilled in the art, where the input signal is converted to a unit of measure such as miles-per-hour or kilometres-per-hour, or in the case of tachometers, rotations-per-minute. Once this signal is developed, a reference angle may be determined from a look-up table. The reference angle represents the desired angular position for the pointer on the gauge corresponding to the determined unit of measure.

Other processing at step 66 may also be carried out. For example, if the pointer is tip-heavy, a compensation term may be obtained from a look-up table in computer memory in response to the reference angle. The signal IDEAL, representing the ideal drive angle for the gauge, is then developed equal to the reference angle plus the pointer tip compensation term. This is one example of the functions which may be performed at step 66 and any functions which develop a signal IDEAL, representing the ideal drive angle for the air core gauge, may be alternatively substituted.

After step 66, the routine moves to step 68 where the variable IDEAL is compared to the variable CENTRE, representing the assumed centre position of magnetic hysteresis where there is zero hysteresis effect. If the difference between IDEAL and CENTRE is less than 1°, the variable COMMAND, representing the output command used to drive the air core gauge, is set equal to IDEAL at step 70 and output at step 94.

If the difference between the variable IDEAL and the variable CENTRE is not less than 1°, the routine moves to step 72 where it is determined if the difference, IDEAL - CENTRE, is between 0 and 4 degrees. If the difference IDEAL - CENTRE falls within the range of 0 to 4 degrees, the routine moves to step 74 where the variable COMMAND is set equal to the variable IDEAL + 0.35° offset. The routine then moves to step 94 to output COMMAND. If the difference, IDEAL - CENTRE, was not between 0 and 4 at step 72, the routine moves to step 76 where the difference, IDEAL - CENTRE is compared to zero. If IDEAL - CENTRE is greater than zero, then it is known at this point that IDEAL - CENTRE is at least 4° and at step 78 the variable COMMAND is set to IDEAL + 0.7°, the maximum offset.

The routine then moves to step 80 where the difference, IDEAL - CENTRE is compared to 5°. If IDEAL - CENTRE is greater than 5°, then a new centre angle is determined at step 82 as CENTRE = COMMAND - 5°. The routine then moves to step 94 to output the variable COMMAND to drive the air core gauge. If at step 76 the difference, IDEAL - CENTRE, is not greater than zero, then it is known that the angular position desired is less than the centre position. The routine then moves to step 84 where the difference, CENTRE - IDEAL, is determined. If CENTRE - IDEAL is within the range of 0 to 4, the routine moves to step 86 where COMMAND is set equal to IDEAL - 0.35°. The routine then moves to step 94 where the variable COMMAND is output to drive the gauge.

If at step 84 the difference, CENTRE - IDEAL, was not between 0 and 4, the routine moves to step 88 where it is known that the difference, CENTRE - IDEAL, is at least 4° so the variable COMMAND is set equal to the variable IDEAL - 0.7°, the maximum offset.

The routine then moves to step 90 where the difference, CENTRE - IDEAL is compared to 5°. If the difference, CENTRE - IDEAL, is greater than 5°, the routine moves to step 92 where a new centre position is determined by according to CENTRE = COMMAND + 5°. If the difference, CENTRE - IDEAL, was not greater than 5° at step 90, the routine moves to step 94. At step 94 the variable COMMAND is output to the sine/cosine drive unit 40 and the routine moves to step 64 to await the next input signal.

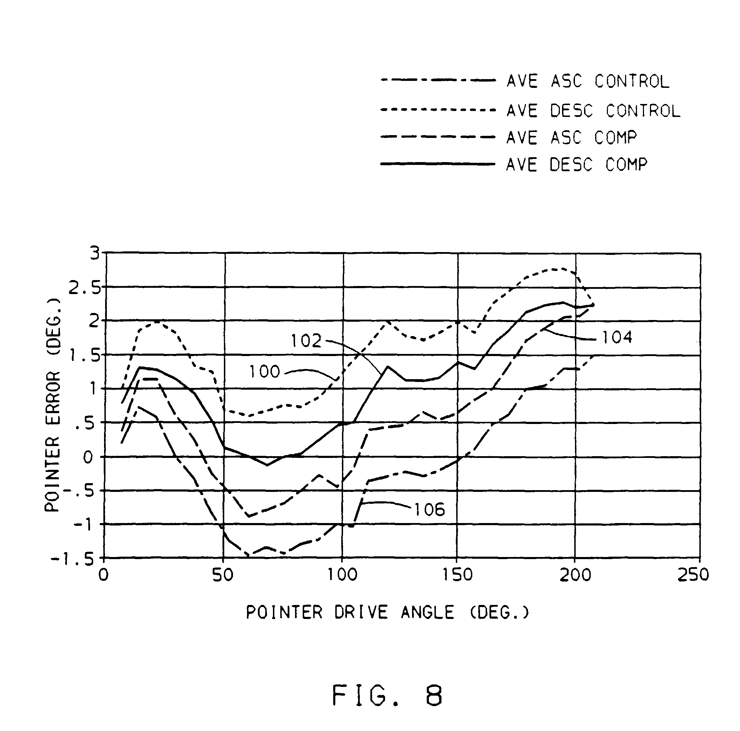

Implementation of the routine shown in Figure 7 and the computer controller 28 shown in Figure 6 provides operation of the gauge apparatus as shown in Figures 4 and 5 and as described above. Implementation into an air core gauge system, such as in a vehicle speedometer can result in improved accuracy of the indicated display, as shown in Figure 8.

The horizontal axis of Figure 8 indicates the gauge drive angle, which ranges from zero to 210° and the vertical axis indicates the pointer error with a zero line corresponding to zero pointer error. Trace 106 represents the pointer position during ascent up the pointer scale and trace 100 represents pointer position during descent of the pointer down the pointer scale. The relatively large error differences between ascent and descent of the pointer due to magnetic hysteresis are exemplified by the large distance between traces 100 and 106. Traces 104 and 102 represent positional error during angular ascent and descent when the method and apparatus as described above are implemented. As can be seen, lines 102 and 104 are much closer together than lines 100 and 106, illustrating the reduction in the error due to magnetic hysteresis.

The improved results illustrated in Figure 8 represent an increase in accuracy of 1.4° or almost 1.6 km/hr (1 mile per hour) in the experimental speedometer tested in which 1.5° angular movement corresponded to 1.6 km/hr (1 mile per hour) on the speedometer graphics.

In the implementation set forth above with reference to Figure 7, the centre angle CENTRE is computed as lagging the variable COMMAND by 5°. Alternatively, CENTRE may be determined as lagging the variable IDEAL by 5°. This alternative can easily be implemented by those skilled in the art by substituting the variable IDEAL for the variable COMMAND when determining the variable CENTRE.

The above-described embodiment can also be used in a vehicle tachometer system, in which an engine speed signal is measured (instead of vehicle speed) and indicated by gauge 52. Likewise, any other air core gauge in which magnetic hysteresis plays an effect may be used with the above described embodiment.

## Claims

1. Gauge driving apparatus comprising a sensor (24) for sensing a predetermined parameter; a gauge assembly including an air core gauge, a pointer (58), and a graphic display (60); and a driver (40) for providing a drive signal to rotate the pointer to an angular position representative of the sensed parameter; characterised by processing means (28) operable in dependence upon the sensed parameter to compute an ideal gauge position and a centre angle representative of an assumed centre position of magnetic hysteresis, to compare the ideal gauge position to the centre position to obtain therefrom an offset value representative of the difference between the ideal gauge position and the centre position and to compute a command signal in response to the ideal gauge position and the offset value; and in that the driver is arranged to provide the drive signal in response to the command signal.

2. Gauge driving apparatus according to claim 1, wherein the processing means is adapted to compute a command signal substantially corresponding to the ideal gauge position when the centre position and the ideal gauge position are within a first range of each other, to compute a command signal substantially corresponding to a sum of the ideal gauge position and a first command offset when the centre position and the ideal gauge position are within a second range of each other, and to compute a command signal substantially corresponding to a sum of the ideal gauge position and a second command offset when the centre position and the ideal gauge position are within a third range of each other.

3. Gauge driving apparatus according to claim 1 or 2, wherein the processing means is adapted to set the centre position substantially to correspond to a previous centre position if the previous centre position and the ideal gauge position are within a predetermined distance of each other and substantially to correspond to a position lagging the ideal gauge position if the centre position and ideal position are outside the predetermined distance of each other.

4. Gauge driving apparatus according to claim 3, wherein the processing means is adapted to set the centre position to lag the ideal gauge position by substantially 5°.

5. A method of driving an air core gauge comprising the step of sensing a predetermined parameter; characterised by the steps of computing an ideal gauge position on the basis of the sensed parameter; computing a centre angle representative of an assumed centre position of magnetic hysteresis of the air core gauge; obtaining a difference signal on the basis of a comparison of the centre position and the ideal gauge position; computing a command signal on the basis of the ideal gauge position and the difference signal; and driving the air core gauge on the basis of the command signal.

6. A method according to claim 5, wherein the step of computing the command signal comprises the steps of determining if the difference signal is within a first, a second or a third range of values; if the difference signal is within the first range of values, setting the command signal substantially to correspond to the ideal gauge position; if the difference signal is within the second range of values, setting the gauge command signal substantially to correspond to a sum of the ideal gauge position and a first command offset; and if the difference signal is within the third range of values, setting the gauge command signal substantially to correspond to a sum of the ideal gauge position and a second command offset.

7. A method according to claim 5 or 6, wherein the step of computing the centre signal comprises the steps of comparing the centre signal to the ideal gauge position; maintaining the centre signal substantially unchanged if the centre signal is within a predetermined distance of the ideal gauge position; and adjusting the centre signal to lag the ideal gauge position if the centre signal is outside the predetermined distance of the ideal gauge position.

8. A method according to claim 7, wherein the centre signal is set to lag the ideal gauge position by substantially 5°.

## Patentansprüche

1. Meßinstrumentantriebsvorrichtung mit einem Sensor (24) zum Wahrnehmen eines vorbestimmten Parameters; einem Meßinstrumentaufbau, der ein Luftkernmeßinstrument, einen Zeiger (58) und eine graphische Anzeige (60) umfaßt; und einem Treiber (40) zum Liefern eines Antriebssignals, um den Zeiger in eine Winkelposition zu drehen, die den wahrgenommenen Parameter darstellt;
**gekennzeichnet** durch
ein Verarbeitungsmittel (28), das in Abhängigkeit von dem wahrgenommenen Parameter betreibbar ist, um eine ideale Meßinstrumentposition und einen Mittenwinkel zu berechnen, der eine angenommene Mittenpositon einer magnetischen Hysterese darstellt, um die ideale Meßinstrumentposition mit der Mittenposition zu vergleichen und somit daraus einen Versatzwert zu erhalten, der die Differenz zwischen der idealen Meßinstrumentposition und der Mittenpositon darstellt, und ein Befehlssignal in Ansprechen auf die ideale Meßinstrumentposition und den Versatzwert zu berechnen; und dadurch, daß der Treiber eingerichtet ist, das Antriebssignal in Ansprechen auf das Befehlssignal zu liefern.

2. Meßinstrumentantriebsvorrichtung nach Anspruch 1, worin das Verarbeitungsmittel ausgelegt ist, ein Befehlssignal zu berechnen, das im wesentlichen der idealen Meßinstrumentposition entspricht, wenn die Mittenposition und die ideale Meßinstrumentposition innerhalb eines ersten Bereichs voneinander liegen, ein Befehlssignal zu berechnen, das im wesentlichen einer Summe der idealen Meßinstrumentposition und eines ersten Befehlsversatzes entspricht, wenn die Mittenpositon und die ideale Meßinstrumentposition innerhalb eines zweiten Bereichs voneinander liegen, und ein Befehlssignal zu berechnen, das im wesentlichen einer Summe der idealen Meßinstrumentposition und eines zweiten Befehlsversatzes entspricht, wenn die Mittenposition und die ideale Meßinstrumentposition innerhalb eines dritten Bereichs voneinander liegen.

3. Meßinstrumentantriebsvorrichtung nach Anspruch 1 oder 2, worin das Verarbeitungsmittel ausgelegt ist, die Mittenposition im wesentlichen so zu setzen, daß sie einer vorigen Mittenposition entspricht, wenn die vorige Mittenposition und die ideale Meßinstrumentposition innerhalb eines vorbestimmten Abstandes voneinander liegen, und daß sie im wesentlichen einer Position entspricht, die gegenüber der idealen Meßinstrumentposition verzögert ist, wenn die Mittenposition und die Idealposition außerhalb des vorbestimmten Abstandes voneinander liegen.

4. Meßinstrumentantriebsvorrichtung nach Anspruch 3, worin das Verarbeitungsmittel ausgelegt ist, die Mittenposition so zu setzen, daß sie gegenüber der Meßinstrumentposition um im wesentlichen 5° verzögert ist.

5. Verfahren zum Antreiben eines Luftkernmeßinstruments mit dem Schritt, daß ein vorbestimmter Parameter wahrgenommen wird; gekennzeichnet durch die Schritte, daß eine ideale Meßinstrumentposition auf der Basis des wahrgenommenen Parameters berechnet wird; ein Mittenwinkel berechnet wird, der eine angenommene Mittenposition von einer magnetischen Hysterese des Luftkernmeßinstruments darstellt; ein Differenzsignal auf das Basis eines Vergleichs der Mittenposition und der idealen Meßinstrumentposition erhalten wird; ein Befehlssignal auf der Basis der idealen Meßinstrumentposition und des Differenzsignals berechnet wird; und das Luftkernmeßinstrument auf der Basis des Befehlssignals angetrieben wird.

6. Verfahren nach Anspruch 5, worin der Schritt des Berechnens des Befehlssignals die Schritte umfaßt, daß bestimmt wird, ob das Differenzsignal innerhalb eines ersten, eines zweiten oder eines dritten Wertebereichs liegt; wenn das Differenzsignal innerhalb des ersten Wertebereichs liegt, das Befehlssignal im wesentlichen so gesetzt wird, daß es der idealen Meßinstrumentposition entspricht; wenn das Differenzsignal innerhalb des zweiten Wertebereichs liegt, das Meßinstrumentbefehlssignal im wesentlichen so gesetzt wird, daß es einer Summe der idealen Meßinstrumentposition und eines ersten Befehlsversatzes entspricht; und wenn das Differenzsignal innerhalb des dritten Wertebereichs liegt, das Meßinstrumentbefehlssignal im wesentlichen so gesetzt wird, daß es einer Summe der idealen Meßinstrumentposition und eines zweiten Befehlsversatzes entspricht.

7. Verfahren nach Anspruch 5 oder 6, worin der Schritt des Berechnens des Mittensignals die Schritte umfaßt, daß das Mittensignal mit der idealen Meßinstrumentposition verglichen wird; das Mittensignal im wesentlichen unverändert aufrechterhalten wird, wenn das Mittensignal innerhalb eines vorbestimmten Abstandes von der idealen Meßinstrumentposition liegt; und das Mittensignal so eingestellt wird, daß es gegenüber der idealen Meßinstrumentposition verzögert ist, wenn das Mittensignal außerhalb des vorbestimmten Abstandes von der idealen Meßinstrumentposition liegt.

8. Verfahren nach Anspruch 7, worin das Mittensignal so eingestellt wird, daß es gegenüber der idealen Meßinstrumentposition um im wesentlichen 5° verzögert ist.

## Revendications

1. Appareil d'entraînement de jauge comprenant un détecteur (24) pour détecter un paramètre prédéterminé; un assemblage de jauge comprenant une jauge sans noyau, une aiguille (58), et un affichage graphique (60); et un circuit d'entraînement (40) pour fournir un signal d'entraînement afin de tourner l'aiguille vers une position angulaire représentant le paramètre détecté; caractérisé par des moyens de traitement (28) qui fonctionnent en liaison avec le paramètre détecté pour calculer une position de jauge idéale et un angle central représentant une position centrale supposée de l'hystérésis magnétique, pour comparer la position de jauge idéale à la position centrale afin d'obtenir à partir de ceci une valeur de décalage représentant la différence entre la position de jauge idéale et la position centrale et pour calculer un signal de commande en réponse à la position de jauge idéale et à la valeur de décalage; et en ce que le circuit d'entraînement est prévu pour fournir le signal d'entraînement en réponse au signal de commande.

2. Appareil d'entraînement de jauge selon la revendication 1, dans lequel les moyens de traitement sont prévus pour calculer un signal de commande correspondant pratiquement à la position de jauge idéale lorsque la position centrale et la position de jauge idéale sont comprises dans une première plage l'une de l'autre, pour calculer un signal de commande correspondant pratiquement à une somme de la position de jauge idéale et d'un premier décalage de commande lorsque la position centrale et la position de jauge idéale sont comprises dans une deuxième plage l'une de l'autre, et pour calculer un signal de commande correspondant pratiquement à une somme de la position de jauge idéale et d'un deuxième décalage de commande lorsque la position centrale et la position de jauge idéale sont comprises dans une troisième plage l'une de l'autre.

3. Appareil d'entraînement de jauge selon la revendication 1 ou 2, dans lequel les moyens de traitement sont prévus pour régler la position centrale afin qu'elle corresponde à une position centrale précédente si la position centrale précédente et la position de jauge idéale se trouvent à une distance prédéterminée l'une de l'autre et afin qu'elle corresponde pratiquement à une position décalant en arrière la position de jauge idéale si la position centrale et la position idéale sont à l'extérieur de la distance prédéterminée l'une de l'autre.

4. Appareil d'entraînement de jauge selon la revendication 3, dans lequel les moyens de traitement sont prévus pour régler la position centrale afin de décaler en arrière la position de jauge idéale d'à peu près 5°.

5. Procédé d'entraînement d'une jauge sans noyau comprenant l'étape consistant à détecter un paramètre prédéterminé; caractérisé par les étapes consistant à calculer une position de jauge idéale d'après le paramètre détecté; à calculer un angle central représentant une position centrale supposée de l'hystérésis magnétique de la jauge sans noyau; à obtenir un signal de différence à partir d'une comparaison de la position centrale et de la position de jauge idéale; à calculer un signal de commande à partir de la position de jauge idéale et du signal de différence; et à entraîner la jauge sans noyau sur la base du signal de commande.

6. Procédé selon la revendication 5, dans lequel l'étape consistant à calculer le signal de commande comprend les étapes consistant à déterminer si le signal de différence se trouve dans une première, une deuxième ou une troisième plage de valeurs; à régler, si le signal de différence se trouve dans la première plage de valeurs, le signal de commande pour qu'il corresponde pratiquement à la position de jauge idéale; à régler, si le signal de différence se trouve dans la deuxième plage de valeurs, le signal de commande pour qu'il corresponde pratiquement à une somme de la position de jauge idéale et d'un premier décalage de commande; et à régler, si le signal de différence se trouve dans la troisième plage de valeurs, le signal de commande de jauge pour qu'il corresponde pratiquement à une somme de la position de jauge idéale et d'un deuxième décalage de commande.

7. Procédé selon la revendication 5 ou 6, dans lequel l'étape consistant à calculer le signal central comprend les étapes consistant à comparer le signal central à la position de jauge idéale; à maintenir le signal central pratiquement inchangé si le signal central se trouve à une distance prédéterminée de la position de jauge idéale; et à régler le signal central afin de décaler en arrièrela position de jauge idéale si le signal central est à l'extérieur de la distance prédéterminée de la position de jauge idéale.

8. Procédé selon la revendication 7, dans lequel le signal central est réglé afin de décaler en arrière la position de jauge idéale de pratiquement 5°.
